# EUROPEAN PATENT SPECIFICATION

(11) **EP 3 054 748 B1**
(45) Date of publication and mention of the grant of the patent: **12.05.2021**
(21) Application number: 14850871.6
(22) Date of filing: 01.10.2014
(51) Int. Cl.: H05H 1/34, H05H 1/24

(54) **METHOD FOR MANUFACTURING MICROPLASMA JET DEVICE**
VERFAHREN ZUR HERSTELLUNG EINER MIKROPLASMASTRAHLVORRICHTUNG
PROCÉDÉ DE FABRICATION D'UN DISPOSITIF À JET DE MICROPLASMA

(30) Priority: 02.10.2013 KR 20130118027; 16.09.2014 KR 20140122736
(43) Date of publication of application: 10.08.2016
(73) Proprietor: Ajou University Industry-Academic Cooperation Foundation, Suwon-si, Gyeonggi-do 443-749 (KR)
(72) Inventor: YANG, Sang Sik, Seoul 137-825 (KR); KIM, Kang Il, Jeonju-si Jeollabuk-do 560-779 (KR); LEE, Chang Min, Seoul 151-818 (KR)
(74) Representative: Viering, Jentschura & Partner mbB Patent- und Rechtsanwälte
(86) International application number: PCT/KR2014/009260
(87) International publication number: WO 2015/050376

(56) References cited:
- WO-A1-01/27969
- WO-A2-2007/087371
- WO-A2-2012/178177
- DE-A1- 19 826 418
- JP-A- 2007 119 305
- JP-A- 2009 245 646
- KR-A- 20090 088 339
- KR-A- 20100 019 253
- KR-A- 20130 023 588
- KR-B1- 101 001 477
- US-A1- 2007 017 636

## Description

### [Technical Field]

The present invention relates to a method of manufacturing a plasma jet device, and more particularly, to a method of manufacturing a microplasma jet device capable of processing a large area, and especially to a method of manufacturing a laminated microplasma jet module.

### [Background Art]

Plasma has been applied in various fields such as the semiconductor industry, the display industry, and for surface modification of materials. Recently, attempts to apply plasma to a bio-medical technology or surface processing of a material such as plastic or fiber have been made. However, in these applications, since an object material that should be treated by the plasma is sensitive to heat, a glow discharge, which is low-temperature plasma, should be used. Because glow discharge is very unstable at normal pressure, a glow-to-arc transition (GAT) in which the glow discharge is transitioned to an arc discharge, which is high-temperature plasma, is likely to occur.

The GAT occurs by heat generated while the plasma is generated, and research on microplasma generated by reducing the capacity of the plasma has been progressing as a method of preventing the GAT.

Conventionally, devices for generating microplasma cause discharge using needles or tubes which are mechanically processed. However, since there is a limit in reducing the size thereof through the mechanical processing and the plasma is generated using a single tube or needle, an area that can be processed at one time is limited.

From DE 198 26 418 A1 and WO 2007/087371 A1 microplasma jet devices are known having a channel layer with a plurality of microfluidic channels arranged in parallel so as to enable a gas for generating plasma to pass therethrough; a first insulating layer bonded to a bottom surface of the channel layer and in which a first plasma generation electrode is formed; and a second insulating layer bonded to a top surface of the channel layer and in which a second plasma generation electrode is formed, wherein the plurality of microfluidic channels comprise inlets located at a first side of the channel layer and outlets located at a second side of the channel layer, wherein the first plasma generation electrode and the second plasma generation electrode are arranged side by side with the outlet of the microfluidic channels interposed therebetween, wherein the first plasma generation electrode extends in a vertical direction of the microplasma jet device corresponding to a third side of the channel layer being perpendicular to the first side of the channel layer, wherein the second plasma generation electrode extends in the vertical direction corresponding to a fourth side of the channel layer being perpendicular to the first side of the channel layer, wherein the first side of the channel layer and the second side of the channel layer are located in the horizontal direction of the microplasma jet device, and wherein the third side of the channel layer and the fourth side of the channel layer are parallel to each other. From JP 2007 119305 A, WO 01/27969 A1, US 2007/017636 A1 and KR 2013 0023588 A further microplasma jet devices are known.

### [Disclosure]

### [Technical Problem]

The present invention is directed to solve the problem of providing a method of manufacturing a microplasma jet device capable of processing a larger area, especially a laminated microplasma jet module.

### [Technical Solution]

This problem is solved by a method of manufacturing a microplasma jet device according to claim 1. Preferable embodiments are subject of the dependent claims.

The present invention provides a method of manufacturing the microplasma jet device including: forming a mold by patterning a photosensitizer on one surface of a substrate to correspond to a plurality of microfluidic channels to be formed; forming a channel layer by pouring a polymer solution into the mold and curing the polymer solution; separating the channel layer from the mold; patterning a seed layer on one surface of a first substrate to correspond to a pattern of a first plasma generation electrode to be formed; forming the first plasma generation electrode by plating the seed layer; forming a first insulating layer by polymer coating a surface of the first substrate, in which the first plasma generation electrode is formed; patterning a seed layer on one surface of a second substrate to correspond to a pattern of a second plasma generation electrode to be formed; forming the second plasma generation electrode by plating the seed layer; forming a second insulating layer by polymer coating a surface of the second substrate, in which the second plasma generation electrode is formed; and bonding the first insulating layer, the channel layer, and the second insulating layer to each other, such that the first insulating layer and the second insulating layer insulate the first plasma generation electrode and the second plasma generation electrode from the microfluidic channels with the channel layer.

The polymer solution may include a PDMS solution.

The patterning of the seed layer may include depositing titanium or gold.

The forming of the first plasma generation electrode or the forming of the second plasma generation electrode may include electroplating the seed layer with nickel.

### [Advantageous Effects]

According to the present invention, a microplasma jet device capable of processing a larger area, especially a laminated microplasma jet module can be manufactured.

### [Description of Drawings]

FIG. 1 is a transparent perspective view illustrating a microplasma jet device which can be manufactured with a method according to an embodiment of the present invention.
FIG. 2 is a cross-sectional view illustrating a microplasma jet device which can be manufactured with a method according to an embodiment of the present invention.
FIG. 3 is a transparent exploded perspective view illustrating a microplasma jet device which can be manufactured with a method according to an embodiment of the present invention.
FIG. 4 is a view illustrating a method of manufacturing a microplasma jet device according to an embodiment of the present invention.
FIG. 5 is a transparent perspective view illustrating a laminated microplasma jet module which can be manufactured with a method according to an embodiment of the present invention.
FIG. 6 is a cross-sectional view illustrating a laminated microplasma jet module which can be manufactured with a method according to an embodiment of the present invention.

### [Modes of the Invention]

Hereinafter, exemplary embodiments of the invention will be described in detail with reference to the accompanying drawings. Like reference numerals in the drawings and descriptions denote like devices, and thus the description thereof will be omitted. Further, when it is determined that detailed explanations of related well-known functions or configurations unnecessarily obscure gist of the embodiments, the detailed description thereof will be omitted.

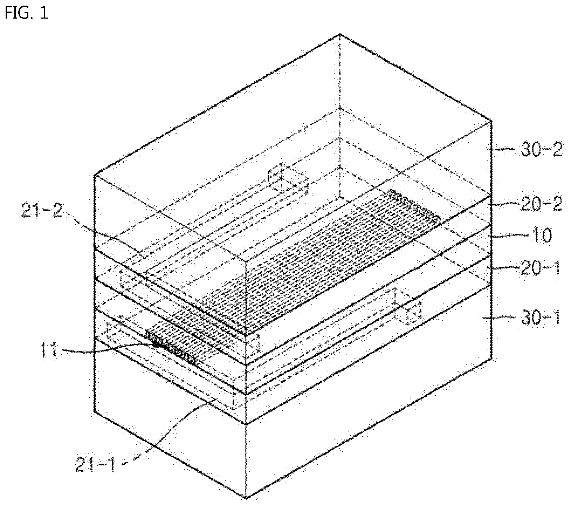

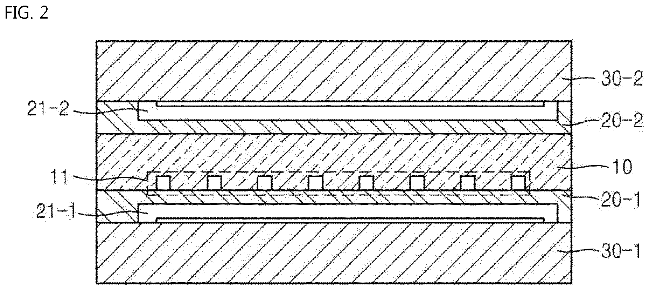

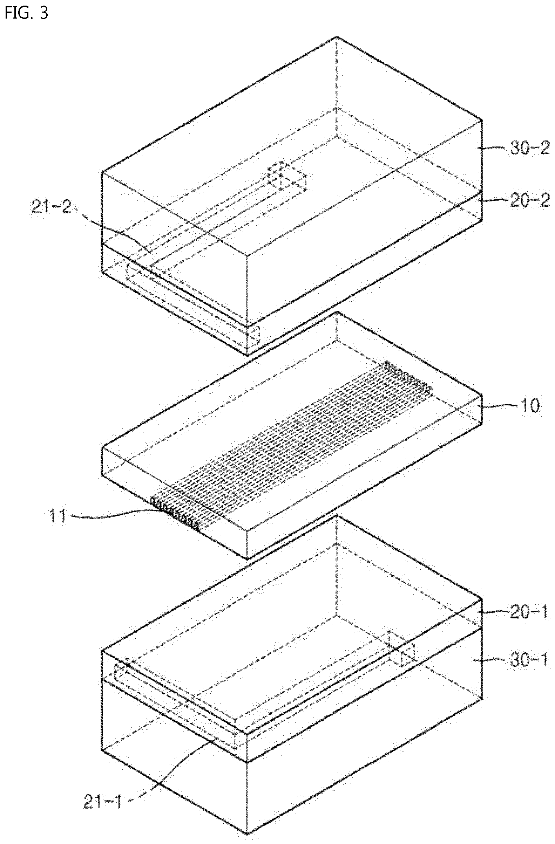

FIGS. 1 to 3 illustrate a structure of a microplasma jet device which can be manufactured with a method according to an embodiment of the present invention, where FIG. 1 is a transparent perspective view illustrating the microplasma jet device which can be manufactured with a method according to the present embodiment, FIG. 2 is a cross sectional view illustrating the microplasma jet device which can be manufactured with a method according to the present embodiment, and FIG. 3 is a transparent exploded perspective view illustrating the microplasma jet device which can be manufactured with a method according to the present embodiment.

Referring to FIGS. 1 to 3, the microplasma jet device which can be manufactured with a method according to the present embodiment includes a channel layer 10 having a plurality of microfluidic channels 11 arranged in parallel so as to enable a gas for generating plasma to pass therethrough, a first insulating layer 20-1 which is bonded to one surface (a lower surface in the drawing) of the channel layer 10 and in which a first plasma generation electrode 21-1 is formed, a second insulating layer 20-2 which is bonded to another surface (an upper surface in the drawing) of the channel layer 10 and in which a second plasma generation electrode 21-2 is formed, a first substrate 30-1 to which the first insulating layer 20-1 is fixed, and a second substrate 30-2 to which the second insulating layer 20-2 is fixed.

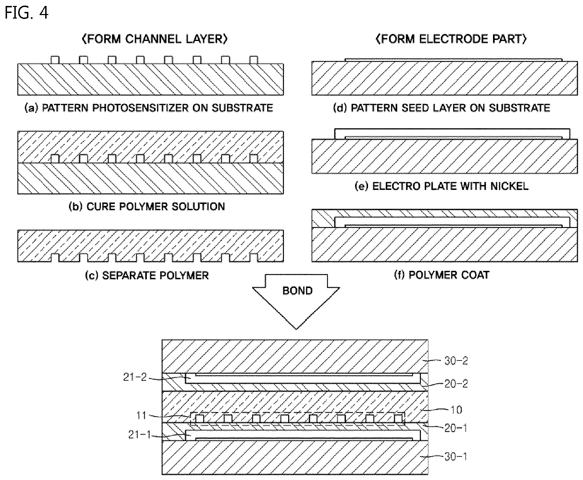

In the embodiment of the present invention, the channel layer 10 in which the plurality of microfluidic channels 11 are formed may be formed using a micromachining process. The plurality of microfluidic channels, each of which having a desired small size, may be formed using the micromachining process. The formation of the channel layer 10 will be described with reference to FIG. 4. The channel layer 10 is preferably made of a polymer based material that can be used for insulating and can be processed as a mold, and here, the polymer-based material may include, for example, polydimethylsiloxane (PDMS).

Referring to FIG. 2, although it is illustrated that the number of the microfluidic channels 11 formed in a single channel layer 10 is, for example, 8, the present invention is not limited thereto, and the number thereof may be, for example, several to several tens. Further, the microfluidic channels 11 of a required number may be implemented according to an area to be processed.

A width of the single microfluidic channel may range from about 100 µm to 500 µm, and a height thereof may be about 100 µm. However, there is no specific limitation on a size of the microfluidic channel, and the size may range, for example, from several tens of µm to several hundreds of µm. A distance between the microfluidic channels may be two times the width, but there is no specific limitation thereon, and the distance may be several times or several hundred times the width of the channel.

Although it is illustrated that the microfluidic channels 11 are formed on a lower side of the channel layer 10 based on the drawings, the microfluidic channels 11 may be formed on an upper side of the channel layer 10. Referring to FIGS. 1 and 3, the microfluidic channels 11 at one side (a right side in the drawing) corresponds to inlets of the gas for generating plasma, and the microfluidic channels 11 at another side (a left side in the drawing) corresponds to outlets of the gas for generating plasma.

The first insulating layer 20-1 and the second insulating layer 20-2 serve to insulate the first plasma generation electrode 21-1 and the second plasma generation electrode 21-2 from the microfluidic channels 11 with the channel layer 10. Specifically, the microfluidic channels 11 are insulated from the first plasma generation electrode 21-1 by the first insulating layer 20-1, and are insulated from the second plasma generation electrode 21-2 by the channel layer 10 and the second insulating layer 20-2.

The first insulating layer 20-1 and the second insulating layer 20-2 may be made of a polymer-based material, and here, the polymer-based material may include, for example, PDMS.

The first plasma generation electrode 21-1 and the second plasma generation electrode 21-2 may be respectively formed in the first insulating layer 20-1 and the second insulating layer 20-2, and may be formed in a predetermined pattern to be suitable for the generation of plasma. For example, the patterns of the first plasma generation electrode 21-1 and the second plasma generation electrode 21-2 may be formed to face each other at portions corresponding to the outlets of the microfluidic channels 11.

The first plasma generation electrode 21-1 and the second plasma generation electrode 21-2 may be respectively formed on surfaces opposite to surfaces in which the first insulating layer 20-1 and the second insulating layer 20-2 are bonded to the channel layer 10 so as to be insulated from the microfluidic channels 11 by the first insulating layer 20-1 and the second insulating layer 20-2. The first plasma generation electrode 21-1 and the second plasma generation electrode 21-2 may be formed, for example, by nickel plating.

The first substrate 30-1 and the second substrate 30-2 respectively fix the first insulating layer 20-1 and the second insulating layer 20-2, respectively fix the first plasma generation electrode 21-1 and the second plasma generation electrode 21-2, and also serve to respectively insulate the first plasma generation electrode 21-1 and the second plasma generation electrode 21-2 from the outside. The first substrate 30-1 and the second substrate 30-2 may be, for example, a glass substrate.

An operating principle of the microplasma jet device which can be manufactured with a method according to the present embodiment is as follows. The gas for generating plasma injected into the inlets of the microfluidic channels 11 is ionized by an electric field formed by the first plasma generation electrode 21-1 and the second plasma generation electrode 21-2 while passing through the microfluidic channels 11, and thus plasma is generated. The generated plasma is pushed by the gas entering the microfluidic channels 11, and is jetted through the outlets of the microfluidic channels 11.

FIG. 4 is a view illustrating a method of manufacturing a microplasma jet device according to an embodiment of the present invention.

The method of manufacturing the microplasma jet device according to the present embodiment mainly includes forming a channel layer 10 in which microfluidic channels 11 are formed, forming an insulating layer 20-1 or 20-2, in which a plasma generation electrode 21-1 or 21-2 are formed, and a substrate 30-1 or 30-2 (hereinafter, referred to as an electrode part), and bonding the channel layer 10 to the electrode parts.

The forming of the channel layer 10 is as follows. A mold is formed by patterning a photosensitizer on one surface of a substrate (for example, a silicon substrate) so as to correspond to a shape of each of the microfluidic channels to be formed (a). Then, a channel layer is formed by pouring a polymer solution into the formed mold and curing the polymer solution (b). Here, the polymer solution may include a PDMS solution. Next, the channel layer in which the microfluidic channels are formed is obtained by separating the cured polymer from the mold (c).

The forming of the electrode parts is as follows. Since an electrode part bonded to a top of the channel layer 10 and an electrode part bonded to a bottom of the channel layer 10 are typically symmetrical and processes of forming the electrode parts are substantially the same, only the process of forming a single electrode part will be described.

A seed layer is patterned on one surface of a substrate (for example, the glass substrate) so as to correspond to a pattern of each of the plasma generation electrodes to be formed (d). Here, the seed layer may be formed by, for example, depositing titanium or gold using an electroplating method, and for example, a photosensitizer and an etching solution may be used in the patterning of the seed layer. Next, the plasma generation electrodes are formed by plating the patterned seed layer (e). Here, the plasma generation electrodes may be formed by electroplating the seed layer with nickel. Next, an insulating layer is formed by polymer coating a surface of the substrate, in which the plasma generation electrodes are formed, so that all of the plasma generation electrodes are covered (f). Through the above described processes such as (d), (e), and (f), the electrode part including the substrate 30-1 or 30-2, the plasma generation electrode 21-1 or 21-2, and the insulating layer 20-1 or 20-2 is formed.

Then, as the channel layer and the electrode parts which are formed in the above-described manner are bonded to each other, the microplasma jet device manufactured according to the embodiment of the present invention is completed. That is, the first insulating layer 20-1 is bonded to a lower surface of the channel layer 10, and the second insulating layer 20-2 is bonded to an upper surface of the channel layer 10. In this case, as the channel layer 10 and the insulating layers 20-1 and 20-2 are to be in close contact with each other and are heated to a determined temperature (for example, about 1500 °C) for a predetermined time (for example, about 15 minutes), the channel layer 10 and the insulating layers 20-1 and 20-2 may be bonded to each other.

A microplasma jet module having a laminated structure may be formed by stacking two or more of the microplasma jet devices according to the embodiment of the present invention. For example, this is because the channel layer and the insulating layer, which are made of a polymer-based material, are easily bonded to each other. According to the embodiment of the present invention, since a size of the module may be increased by as much as desired by stacking the microplasma jet devices, a microplasma jet module that can process as large an area as desired at one time may be implemented.

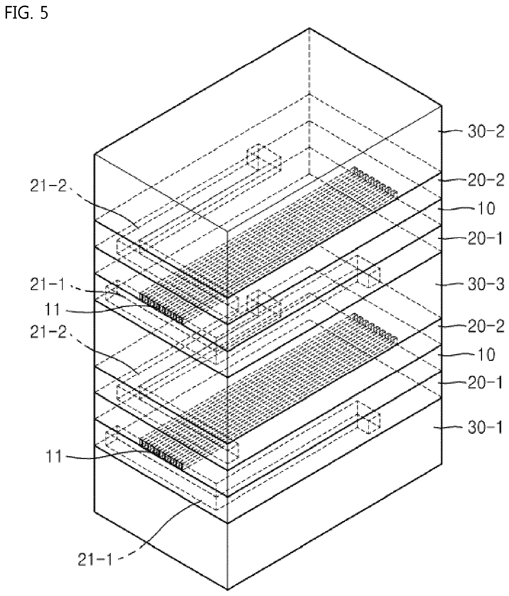

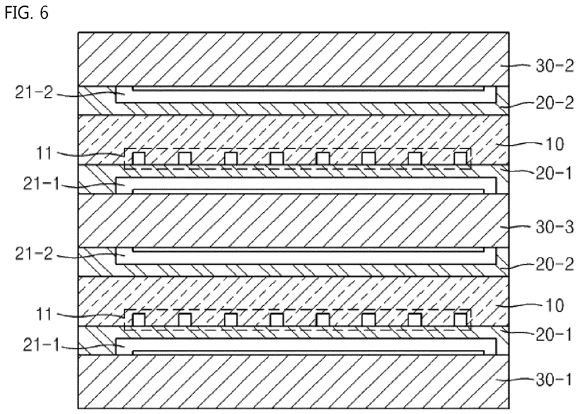

FIGS. 5 and 6 illustrate a structure of a laminated microplasma jet module which can be manufactured with a method according to an embodiment of the present invention, where FIG. 5 is a transparent perspective view illustrating the laminated microplasma jet module manufactured according to the present embodiment and FIG. 6 is a cross-sectional view illustrating the laminated microplasma jet module manufactured according to the present embodiment.

Referring to FIGS. 5 and 6, the laminated microplasma jet module which can be manufactured with a method according to the present embodiment includes channel layers 10 having a plurality of microfluidic channels 11 arranged in parallel so as to enable a gas for generating plasma to pass therethrough, two microplasma jet devices each including a first insulating layer 20-1 which is bonded to one surface (a lower surface in the drawing) of the channel layer 10 and in which a first plasma generation electrode 21-1 is formed and a second insulating layer 20-2 which is bonded to another surface (an upper surface in the drawing) of the channel layer 10 and in which a second plasma generation electrode 21-2 is f01med, wherein the two microplasma jet devices are laminated by interposing an intermediate substrate 30-3 therebetween, a first substrate 30- 1 to which the first insulating layer 20-1 of a lower microplasma jet device is fixed, and a second substrate 30-2 to which the second insulating layer 20-2 of an upper microplasma jet device is fixed.

In the present embodiment, although two of the microplasma jet devices being laminated is described as an example, two or more of the microplasma jet devices may be laminated.

A process of forming the laminated microplasma jet module of FIGS. 5 and 6 is as follows.

Two channel layers 10 may be formed through the above-described process of forming the channel layer.

Further, through the above-described process of forming electrode part, two electrode parts, that is, a lower electrode part including the first substrate 30-1, the first plasma generation electrode 21-1, and the first insulating layer 20-1, and an upper electrode part including the second substrate 30-2, the second plasma generation electrode 21-2, and the second insulating layer 20-2, may be formed.

Referring to FIGS. 5 and 6, the plasma generation electrodes 21-1 and 21-2 and the insulating layers 20-1 and 20-2 are respectively formed on both side surfaces of the intermediate substrate 30-3. Therefore, an intermediate electrode part including the intermediate substrate 30-3 and the plasma generation electrodes 21-1 and 21-2 and the insulating layers 20-1 and 20-2 which are formed on the both side surfaces of the intermediate substrate 30-3 may be formed through a process similar to the above-described process of forming the electrode part. Since the above-described process of forming the electrode part is a process of forming the plasma generation electrode and the insulating layer on only one side surface of the substrate, the intermediate electrode part may be formed through a process in which the above-described process of forming the electrode part is slightly modified, that is, through a process of respectively forming the plasma generation electrode and the insulating layer on both side surfaces of the substrate.

When the two channel layers, the upper and lower electrode parts, and the intermediate electrode part, which are formed in this manner, are bonded in an order illustrated in FIGS. 5 and 6, the laminated microplasma jet module manufactured according to the present embodiment is completed.

In the present embodiment, although two of the microplasma jet devices being laminated is described as an example, two or more of the microplasma jet devices may be laminated.

A process of forming the laminated microplasma jet module of FIGS. 5 and 6 is as follows.

Two channel layers 10 may be formed through the above-described process of forming the channel layer.

Further, through the above-described process of forming electrode part, two electrode parts, that is, a lower electrode part including the first substrate 30-1, the first plasma generation electrode 21-1, and the first insulating layer 20-1, and an upper electrode part including the second substrate 30-2, the second plasma generation electrode 21-2, and the second insulating layer 20-2, may be formed.

Referring to FIGS. 5 and 6, the plasma generation electrodes 21-1 and 21-2 and the insulating layers 20-1 and 20-2 are respectively formed on both side surfaces of the intermediate substrate 30-3. Therefore, an intermediate electrode part including the intermediate substrate 30-3 and the plasma generation electrodes 21-1 and 21-2 and the insulating layers 20-1 and 20-2 which are formed on the both side surfaces of the intermediate substrate 30-3 may be formed through a process similar to the above-described process of forming the electrode part. Since the above-described process of forming the electrode part is a process of forming the plasma generation electrode and the insulating layer on only one side surface of the substrate, the intermediate electrode part may be formed through a process in which the above-described process of forming the electrode part is slightly modified, that is, through a process of respectively forming the plasma generation electrode and the insulating layer on both side surfaces of the substrate.

When the two channel layers, the upper and lower electrode parts, and the intermediate electrode part, which are formed in this manner, are bonded in an order illustrated in FIGS. 5 and 6, the laminated microplasma jet module according to the present embodiment is completed.

While the present invention has been particularly described with reference to exemplary embodiments, it should be understood by those skilled in the art that various changes in form and details may be made without departing from the scope of the present invention, said scope determined by the appended claims.

## Claims

1. A method of manufacturing a microplasma jet device, the method comprising:
forming a mold by patterning a photosensitizer on one surface of a substrate to correspond to a plurality of microfluidic channels (11) to be formed;
forming a channel layer (10) by pouring a polymer solution into the mold and curing the polymer solution;
separating the channel layer (10) from the mold,
**characterized by**
patterning a seed layer on one surface of a first substrate to correspond to a pattern of a first plasma generation electrode to be formed;
forming the first plasma generation electrode (21-1) by plating the seed layer;
forming a first insulating layer (20-1) by polymer coating a surface of the first substrate, in which the first plasma generation electrode (21-1) is formed;
patterning a seed layer on one surface of a second substrate to correspond to a pattern of a second plasma generation electrode to be formed;
forming the second plasma generation electrode by plating the seed layer;
forming a second insulating layer (20-2) by polymer coating a surface of the second substrate, in which the second plasma generation electrode is formed; and
bonding the first insulating layer, the channel layer, and the second insulating layer (20-2) to each other, such that the first insulating layer (20-1) and the second insulating layer (20-2) insulate the first plasma generation electrode (21-1) and the second plasma generation electrode (21-2) from the microfluidic channels (11) with the channel layer (10).

2. The method of claim 1, wherein the polymer solution includes a PDMS solution.

3. The method of claim 1, wherein patterning of the seed layer includes depositing titanium or gold.

4. The method of claim 1, wherein the forming of the first plasma generation electrode (21-1) or the forming of the second plasma generation electrode (21-2) includes electroplating the seed layer with nickel.

## Patentansprüche

1. Verfahren zum Herstellen einer
Mikroplasmastrahlvorrichtung, wobei das Verfahren aufweist:
Ausbilden einer Form durch Strukturieren eines Photosensibilisators auf einer Oberfläche eines Substrats, um mit einer Mehrzahl von auszubildenden Mikrofluidkanälen (11) zu korrespondieren,
Ausbilden einer Kanalschicht (10) durch Gießen einer Polymerlösung in die Form und Aushärten der Polymerlösung,
Trennen der Kanalschicht (10) von der Form,
**gekennzeichnet durch**:
Strukturieren einer Keimschicht auf einer Oberfläche eines ersten Substrats, um mit einem Muster einer auszubildenden ersten Plasmaerzeugungselektrode zu korrespondieren,
Ausbilden der ersten Plasmaerzeugungselektrode (21-1) durch Plattieren der Keimschicht,
Ausbilden einer ersten Isolierschicht (20-1) durch Polymerbeschichten einer Oberfläche des ersten Substrats, in der die erste Plasmaerzeugungselektrode (21-1) ausgebildet ist,
Strukturieren einer Keimschicht auf einer Oberfläche eines zweiten Substrats, um mit einem Muster einer auszubildenden zweiten Plasmaerzeugungselektrode zu korrespondieren,
Ausbilden der zweiten Plasmaerzeugungselektrode durch Plattieren der Keimschicht,
Ausbilden einer zweiten Isolierschicht (20-2) durch Polymerbeschichten einer Oberfläche des zweiten Substrats, in der die zweite Plasmaerzeugungselektrode ausgebildet ist, und
Verbinden der ersten Isolierschicht, der Kanalschicht und der zweiten Isolierschicht (20-2) miteinander, so dass die erste Isolierschicht (20-1) und die zweite Isolierschicht (20-2) die erste
Plasmaerzeugungselektrode (21-1) und die zweite Plasmaerzeugungselektrode (21-2) von den Mikrofluidkanälen (11) mit der Kanalschicht (10) isolieren.

2. Verfahren gemäß Anspruch 1, wobei die Polymerlösung eine PDMS-Lösung aufweist.

3. Verfahren gemäß Anspruch 1, wobei das Strukturieren der Keimschicht ein Aufbringen von Titan oder Gold aufweist.

4. Verfahren gemäß Anspruch 1, wobei das Ausbilden der ersten Plasmaerzeugungselektrode (21-1) oder das Ausbilden der zweiten Plasmaerzeugungselektrode (21-2) ein Elektroplattieren der Keimschicht mit Nickel aufweist.

## Revendications

1. Procédé destiné à fabriquer un dispositif à jet de microplasma, le procédé comprenant les étapes suivantes :
former un moule en déposant un motif de photosensibilisateur sur une surface d'un substrat de façon à correspondre à une pluralité de canaux microfluidiques (11) à former ;
former une couche de canaux (10) en versant une solution polymère dans le moule et en durcissant la solution polymère ;
séparer la couche de canaux (10) du moule,
**caractérisé par** les étapes suivantes :
déposer un motif de couche de germe sur une surface d'un premier substrat de façon à correspondre à un motif d'une première électrode de génération de plasma à former ;
former la première électrode de génération de plasma (21-1) en plaquant la couche de germe ;
former une première couche isolante (20-1) en revêtant d'un polymère une surface du premier substrat, dans laquelle est formée la première électrode de génération de plasma (21-1) ;
déposer un motif de couche de germe sur une surface d'un second substrat de façon à correspondre à un motif d'une seconde électrode de génération de plasma à former ;
former la seconde électrode de génération de plasma en plaquant la couche de germe ;
former une seconde couche isolante (20-2) en revêtant d'un polymère une surface du second substrat, dans laquelle est formée la seconde électrode de génération de plasma ; et
coller les unes aux autres la première couche isolante, la couche de canaux, et la seconde couche isolante (20-2), de telle sorte que la première couche isolante (20-1) et la seconde couche isolante (20-2) isolent la première électrode de génération de plasma (21-1) et la seconde électrode de génération de plasma (21-2) des canaux microfluidiques (11), avec la couche de canaux (10).

2. Procédé selon la revendication 1, où la solution polymère comprend une solution de PDMS.

3. Procédé selon la revendication 1, où l'étape consistant à déposer un motif de couche de germe inclut une étape consistant à déposer du titane ou de l'or.

4. Procédé selon la revendication 1, où l'étape consistant à former la première électrode de génération de plasma (21-1) ou la seconde électrode de génération de plasma (21-2) inclut une étape consistant à plaquer la couche de germe avec du nickel.
